Europäisches Patentamt

European Patent Office

Office européen des brevets

(11) Numéro de publication: **0 433 514 A1**

## (12) DEMANDE DE BREVET EUROPEEN

(21) Numéro de dépôt: **89403560.9**

(22) Date de dépôt: **19.12.89**

(51) Int. Cl.5: **G08C 25/02**, **B61L 1/20**, **H03K 17/18**, **G08G 1/097**

(43) Date de publication de la demande:
**26.06.91 Bulletin 91/26**

(84) Etats contractants désignés:
**AT BE CH DE ES GB GR IT LI LU NL SE**

(71) Demandeur: **CEGELEC**
**13, rue Antonin-Raynaud**
**F-92309 Levallois-Perret(FR)**

(72) Inventeur: **Pauly, Jean**
**9, rue des Campanules**
**F-91090 Lisses(FR)**

(74) Mandataire: **Weinmiller, Jürgen et al**
**Lennéstrasse 9 Postfach 24**
**W-8133 Feldafing(DE)**

(54) **Agencement d'entrée-sortie testable pour charge découpléé par transformateur.**

(57) Agencement d'entrée-sortie, pour test préalable et commande d'une charge électrique (2) découplée par transformateur (5). Une entrée (E) agit sur un premier organe de commutation (6) inséré en série avec un enroulement primaire du transformateur dans un premier circuit d'alimentation, de cet enroulement primaire. Une sortie (S) fournit un signal à partir de la tension présente aux bornes d'une résistance (7), dite de sortie, reliée en série avec l'enroulement primaire du transformateur, dans le circuit d'alimentation de cet enroulement. Un second organe de commutation (3) est inséré en série avec la charge dans le circuit d'alimentation de cette charge, il est commandé à partir de l'entrée de l'agencement, via le transformateur et un montage redresseur (10) connecté aux bornes de l'enroulement secondaire de ce transformateur. Un montage commutateur d'impédance (13, 16), est connecté aux bornes du second enroulement pour agir sur la sortie de l'agencement en modifiant la tension aux bornes de la résistance de sortie. Il est commandé par le courant d'alimentation traversant le second organe de commutation et il est apte à commuter en conséquence une impédance auxiliaire (17)

FIG.1

## AGENCEMENT D'ENTRÉE-SORTIE TESTABLE POUR CHARGE DÉCOUPLÉE PAR TRANSFORMATEUR.

L'invention concerne un agencement d'entrée-sortie testable pour charge découplée par transformateur.

Dans de nombreuses applications industrielles, on télécommande électriquement des charges, telles que des actionneurs, des moteurs etc, au travers de transformateurs qui isolent ces charges et les organes de commutation associés, des logiques de commande chargées de leur déclenchement et de leur supervision.

Les logiques de commande et/ou les personnels exploitants n'ont souvent pas la possibilité de déterminer directement si les ordres transmis par l'intermédiaire des transformateurs produisent les résultats escomptés et l'on s'efforce donc de prévoir, au niveau des équipements télécommandés, des moyens aptes à produire et transmettre des informations en retour correspondant aux résultats obtenus.

Il est également intéressant pour certaines exploitations de pouvoir vérifier, avant l'envoi d'un ordre, que l'équipement commandé est en état d'accomplir cet ordre, sans pour cela le déclencher.

La présente invention propose donc un agencement d'entrée testable pour charge découplée par transformateur.

Selon une caractéristique de l'invention l'agencement d'entrée-sortie, prévu pour permettre le test préalable et la commande d'alimentation d'une charge, comporte :

- une entrée agissant sur un premier organe de commutation inséré en série avec un enroulement primaire du transformateur dans un premier circuit d'alimentation, qu'il commande, de cet enroulement primaire ;

- une sortie fournissant un signal à partir de la tension présente aux bornes d'une résistance, dite de sortie, reliée en série avec l'enroulement primaire du transformateur, dans le circuit d'alimentation de cet enroulement ;

- un circuit secondaire comportant un second organe de commutation qui est inséré en série avec la charge dans un second circuit d'alimentation, qu'il commande, de cette charge et qui est commandé à partir de l'entrée de l'agencement, via le transformateur et un agencement redresseur connecté aux bornes d'un enroulement secondaire de ce transformateur, ledit circuit secondaire comportent de plus un montage commutateur d'impédance, qui est sensible au courant d'alimentation traversant le second organe de commutation et qui est apte à connecter en conséquence une impédance auxiliaire aux bornes du second enroulement pour actionner la sortie de l'agencement en modifiant la tension aux bornes de la résistance, dite de sortie.

La figure 1 présente le schéma de réalisation d'un agencement d'entrée-sortie testable selon l'invention pour charge découplée par transformateur.

La figure 2 présente le schéma d'une variante de réalisation de l'agencement montré figure 1.

Les figures 3A à 3D présentent des diagrammes relatifs au test d'un agencement d'entrée-sortie selon la figure 2.

La figure 4 présente une variante de l'agencement présenté en figure 2.

Les figures 5A à 5E présentent des diagrammes relatifs au test d'un agencement d'entrée-sortie selon la figure 4.

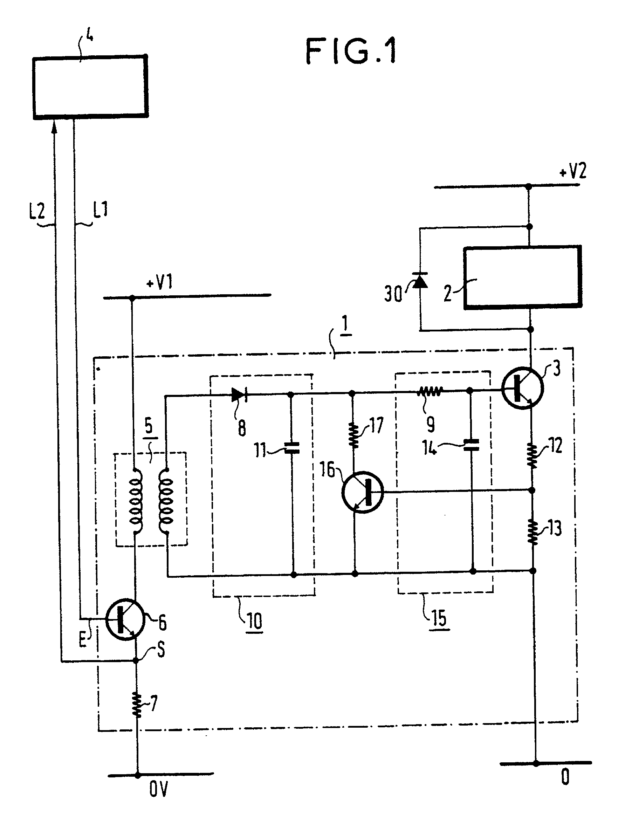

L'agencement d'entrée-sortie testable 1 montré en figure 1 est destiné à desservir une charge 2, constituée par exemple par un enroulement d'un contacteur, d'une électro-vanne, d'un moteur ou autre, cette charge supposée inductive est classiquement protégée contre les surtensions par une diode 30.

L'alimentation électrique de la charge 2 est commandée par l'intermédiaire d'un organe de commutation 3, ici symbolisé par un premier transistor NPN, dit d'activation. La commande de l'organe de commutation 3, en l'occurence de la base du transistor, s'effectue à partir d'une unité de commande 4 par l'intermédiaire d'un transformateur de séparation 5, ici inclus dans l'agencement d'entrée-sortie testable 1. L'unité de commande 4 est de type logique, elle est par exemple organisée autour d'un processeur non figuré qui assure l'envoi d'ordres et le traitement des comptes-rendus faisant suite à ses ordres. Les échanges s'effectuent au travers d'interfaces appropriées et sous le contrôle d'un programme enregistré dans des mémoires associées au processeur.

Les commandes sont transmises au primaire du transformateur 5 par l'intermédiaire d'un organe de commutation 6 représenté par un second transistor NPN d'activation qui est classiquement attaqué au niveau de sa base E, via une liaison L1. Le signal de commande est par exemple un signal à 2MHz émanant d'une interface appropriée de l'unité de commande 4 qui est activée lorsque l'organe de commutation 3 doit être actionné pour alimenter électriquement la charge 2.

L'enroulement primaire du transformateur 5 et l'organe de commutation 6 sont connectés en série entre des potentiels d'alimentation continus, par exemple +V1 et 0V, via une résistance de limitation de courant 7, plaçée ici entre l'émetteur du transistor et le potentiel 0V.

Le point de sortie S, commun à cet émetteur de transistor et à la résistance 7, fournit à l'unité de commande, via une liaison L2, une indication sur la valeur du courant traversant l'enroulement primaire du transformateur 5, la liaison collecteur-émetteur du transistor et la résistance 7.

Un enroulement secondaire du transformateur 5 permet la transmission de signaux de commande à l'organe de commutation 3, dans l'exemple proposé ici, une borne de cet enroulement est reliée par une diode 8 et une résistance 9 à la base du premier transistor d'activation constituant l'organe de commutation 3.

La diode 8 fait partie d'un montage redresseur 10 comprenant également, ici, une capacité 11 connectée en parallèle sur le dispositif constitué par le secondaire du transformateur 5 et la diode 8 en série.

Le courant redressé fourni par le montage redresseur 10, lorsque le signal de commande à 2 MHz est appliqué au second transistor d'activation, est lui-même appliqué à la base du premier transistor d'activation afin de le rendre passant, ce qui assure en conséquence l'alimentation la charge 2. A cet effet celle-ci est placé en série, avec la liaison collecteur émetteur du premier transistor d'activation et deux résistances 12 et 13, entre des potentiels d'alimentation ici référencés +V2 et 0, la différence de potentiel aux bornes de ces éléments en série étant souvent très supérieure à celle présente aux bornes de l'ensemble que forme le primaire du transformateur 5, l'organe de commutation 6 et la résistance 7 en série.

La résistance 9 est associé à une capacité 14 pour former un montage temporisateur 15 dans lequel la capacité est insérée entre le point commun à la résistance 9 et à la base du premier transistor d'activation et l'extrémité de la résistance 13 qui est reliée au potentiel 0.

Un transistor 16 de type NPN est relié en série avec une résistance 17 par sa liaison collecteur-émetteur en un branche connectée en parallèle avec le condensateur 11 entre la cathode de la diode 8 et le potentiel 0.

L'envoi d'un ordre d'alimentation par l'unité de commande 4 à l'organe de commutation 6, qui se traduit ici par la conduction dudit second transistor d'activation entraîne le passage d'un courant à travers la branche constituée par l'enroulement primaire du transformateur 5, le second transistor et la résistance 7. La liaison L2 permet à l'unité de commande 4 de connaître l'existence et la valeur de la tension créée aux bornes de la résistance 7 en réponse à l'ordre qu'elle a envoyé et par conséquent de tester la continuité de la continuité de la branche incluant l'enroulement primaire du transformateur. Cette surveillance de la tension aux bornes de la résistance 7, qui est fonction de courant circulant dans l'enroulement primaire du transformateur 5, permet aussi de détecter toute défaillance de l'agencement d'entrée-sortie qui produit une variation anormale d'impédance et donc de courant.

Le courant créé dans l'enroulement secondaire du transformateur 5 est appliqué à la base du premier transistor d'activation, après redressement par le montage 10, et il entraîne normalement la commutation de ce transistor qui assure l'alimentation de la charge 2 en devenant passant.

Un courant traverse alors le pont diviseur constitué par les résistances 12 et 13 en série, ce qui polarise la base du transistor 16 de manière qu'il devienne lui aussi passant.

La résistance 17 qui est par exemple de l'ordre de cent cinquante ohms vient se connecter en parallèle aux bornes de l'enroulement secondaire du transformateur 5 modifiant l'impédance secondaire telle que vue du primaire et entraînant en conséquence une modification du courant circulant au niveau de la résistance 7. Cette modification est détectée au point S et prise en compte par l'unité de commande 4 via la liaison L2. Cette unité de commande 4 est donc capable de savoir si l'ordre qu'elle a lancé a été exécuté.

Il est également possible de vérifier le circuit de commande de l'organe de commutation 3 sans déclencher la charge 2. A cet effet le signal de commande délivré par l'unité de commande au transformateur 5 est limité à une impulsion fine. Cette impulsion est normalement absorbée par le montage temporisateur 15, composé par exemple par une résistance 9 et d'une capacité 14.

Elle est sans action sur l'organe de conduction 3, sauf un cas de défaut éventuel de ce dernier amenant sa conduction et par conséquent celle du transistor 16.

En ce cas, ce dernier modifie l'impédance présente ou secondaire du transformateur 5, ce qui influence brièvement le courant au primaire de ce transformateur et la tension aux bornes de la résistance 7. L'unité de commande 4 est alors informée de cette modification, via la liaison L2, et est donc à même de prendre les mesures nécessaires.

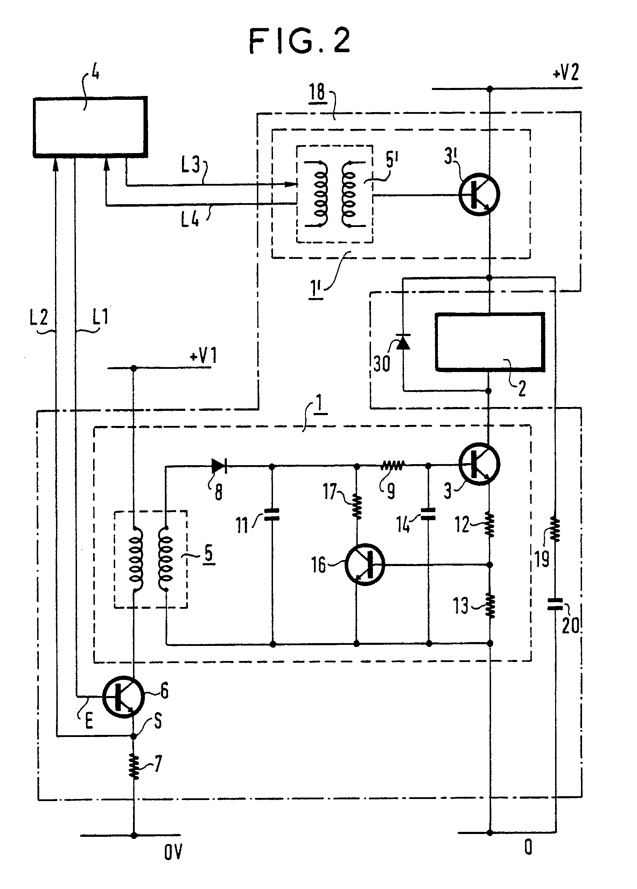

L'agencement proposé en figure 2 constitue une variante exploitable dans le cas où, pour des raisons de sécurité, on duplique l'organe de commutation 3 contrôlant l'alimentation de la charge 2 par un organe de commutation 3′, situé de l'autre côté de la charge 2 et intégré dans un dispositif 1′ identique à l'agencement d'entrée-sortie 1 décrit précédemment. Le disposi tif 1′ qui est par exemple actionné et supervisé par l'unité de commande 4 via des liaisons L3, L4 analogues aux liaisons L1, L2 est organisé autour d'un transformateur 5′ semblable au transformateur 5 dans son agencement. L'ensemble formé par ce dispositif 1′ et l'agencement 1 forme un nouvel agencement d'entrée-sortie testable 18 incorporant un circuit RC série, composé d'une résistance 19 et d'une capacité 20, connecté, entre le potentiel 0 et l'émetteur du transistor 3', en parallèle sur la branche formée par la charge 2, la liaison émetteur-collecteur du transistor 3 et les résistances 12, 13 en série.

Selon l'invention, il est prévu de contrôler le fonctionnement complet du circuit incluant la charge, les organes de commutation 3 et 3' après celle de leurs circuits de commande respectifs réalisée de la manière évoquée en liaison avec la figure 1 et ceci sans commander la charge.

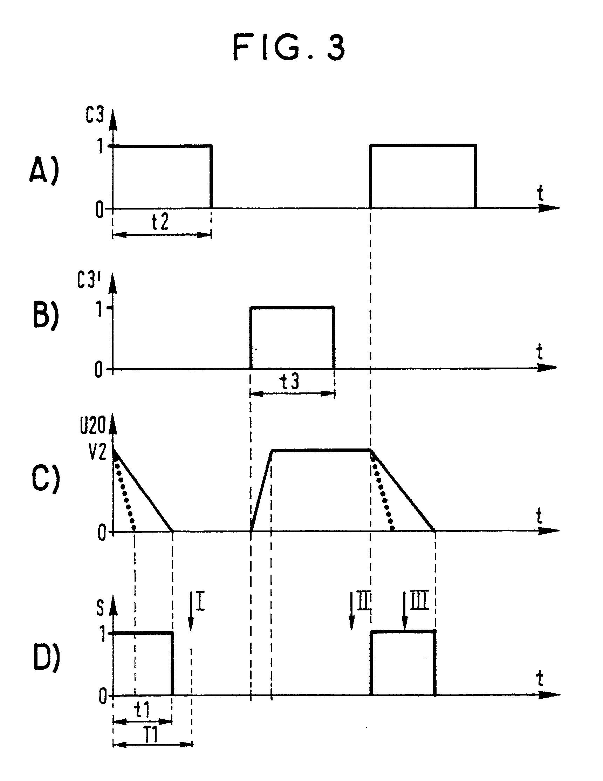

A cet effet, dans une première phase, l'unité de commande 4 actionne l'organe de commutation 6 en lui envoyant une impulsion de signal à 2 MHz dont la durée correspond à celle du premier créneau de valeur binaire "un" figurant sur la figure 3A.

L'organe de commutation 3 est alors commandé et conduit pour la durée du premier créneau dans le temps représenté en figure 3A ; cette dernière montre sous forme binaire les intervalles où l'organe de commutation 3 est soit à l'état passant, qui correspond à un niveau binaire "un" du diagramme, soit à l'état bloqué traduit par un niveau binaire "zéro".

Simultanément l'organe de commutation 3' reste à l'état non-conducteur, en l'absence de commande d'activation provenant de l'unité de commande 4 via la liaison L3 -figure 3B-.

Le condensateur 20 se décharge en raison de l'état passant de l'organe de commutation 3, si précédemment il avait été chargé par l'intermédiaire de l'organe de commutation 3' relié au potentiel +V2 et sauf si cet organe de commutation 3' est resté à l'état conducteur par suite d'une défaillance.

Le transistor 16 est rendu conducteur par le courant circulant via la branche formée par l'organe de commutation 3 et les résistances 12, 13 en série, il entraîne le passage au primaire du transformateur 5 d'un courant primaire prenant en compte la présence de la résistance 17 connectée dans le circuit raccordé au secondaire de ce transformateur.

Ce courant primaire entraîne la création d'une tension aux bornes de la résistance 7 qui est susceptible d'être détectée par l'unité de commande et qui est traduite par un niveau binaire un sur le diagramme de la figure 3D.

La tension U20 aux bornes de la capacité 20 qui est représentée en figure 3C décroît, à partir de l'ouverture de l'organe de connexion 3 rendu passant, jusqu'à décharge complète en un laps de temps qui peut être très court si la charge est en court-circuit par suite d'une défaillance -tracé en pointillé-. La fin de décharge entraîne la mise hors-circuit de la résistance 17 au secondaire du transformateur 5 et se traduit par une réduction du courant primaire qui équivaut à un signal binaire de niveau zéro au point de sortie S et sur le diagramme correspondant de la figure 3D.

Une premier relevé I est effectué au point de sortie S par l'unité de commande 4 via la liaison L2, après un laps de temps T1 supérieur au temps de décharge normal t1 du condensateur 20 au travers de la branche comportant la charge 2 et les résistances 12, 13.

La présence d'un niveau binaire "un" au point de sortie S après le relevé I traduirait la présence d'un courant dans l'organe de commutation 3' qui serait alors passant, en court-circuit. Un tel défaut est normalement détecté par ledit dispositif 1' avant de l'être un niveau du point R par l'agencement 1, dans la mesure où le dispositif 1', comme l'agencement d'entrée-sortie 1 décrit en liaison avec la figure 1, permet de vérifier préalablement l'état de l'organe de commutation 3'.

Après un temps t2 > T1, la fin du signal de commande sur la liaison L1 à destination de l'organe de commutation 3, via le transformateur 5, entraîne normalement le passage de ce dernier à l'état bloqué et permet le déroulement d'une nouvelle phase de test où l'organe de commutation 3' est à son tour rendu passant par un signal de commande de même type que celui fourni à l'organe de commutation 3.

Ce signal de commande représenté en figure 3B, entraîne la charge de la capacité 20 dont la tension croît pendant un temps t3 jusqu'à une valeur limite représentée en figure 3C, ce signal de commande n'est préférablement maintenu qu'un temps t3 limité après la fin du délai prévu pour la charge de la capacité 20.

Un second relevé II est alors effectué au niveau du point de sortie S après la fin du signal de commande de l'organe de commutation 3'.

Ce second relevé conduit normalement à la détection d'un niveau zéro, sauf si l'organe de commutation 3 est passant par suite d'un défaut et entraîne l'insertion de la résistance 17 au secondaire du transformateur 5.

Toutefois un tel défaut est normalement détecté préalablement, pour les raisons évoquées plus haut, en cas de défaut de l'organe de commutation 3'.

Une seconde commande de l'organe de commutation 3 est alors déclenchée par l'unité de commande 4, via la liaison L1, en vue de rendre cet organe à nouveau passant. La capacité 20 se décharge alors via la charge 2 et les résistances 12 et 13, si l'organe de commutation 3 n'était pas préalablement passant par défaut.

Un troisième relevé III est effectué au point de sortie S sur ordre de l'unité de commande 4 à un instant quelconque pendant le laps de temps correspondant à la période de décharge normale de la capacité 20. Le point de sortie S est normalement à un niveau binaire un, sauf si l'organe de commutation 3 était préalablement passant par suite d'un défaut.

La combinaison des relevés I, II et III successivement effectués au cours d'une même opération de test permet de savoir si l'agencement d'entrée-sortie est en un état normal que traduit une combinaison zéro, zéro, un des trois relevés I, II, III successifs, tant autre combinaison traduisant un défaut que la succession de relevés permet de localiser. Ceci permet un test complet avant fonctionnement, étant entendu que la recherche des causes d'un défaut constaté est le plus souvent effectuée, hors de l'installation, après retrait du circuit affecté.

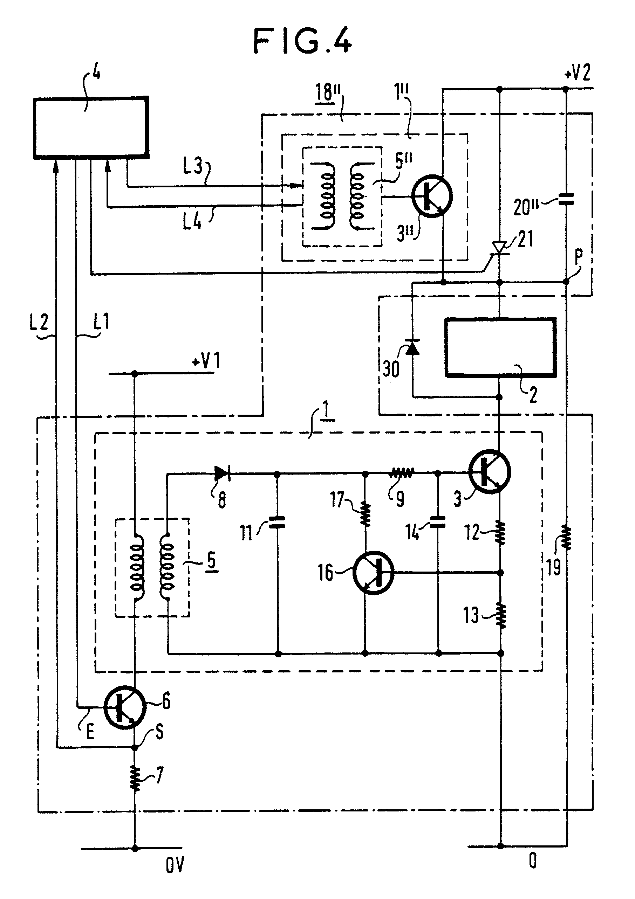

L'agencement présenté en figure 4 constitue une variante de celui présenté en figure 2, qui est adaptée au cas ou l'organe de commutation 3' est constitué par un thyristor de puissance en parallèle avec un transistor 3" chargé de le court-circuiter lors de son extinction.

Dans de tels arrangements on dispose classiquement un condensateur 20" chargé d'absorber les surtensions et monté en parallèle à la jonction anode-cathode du thyristor 21 dont la gâchette est sous le contrôle de l'unité de commande 4.

Il est alors possible de connecter la résistance 19 au point P commun à la capacité 20", à la cathode du thyristor 21 et à l'émetteur du transistor 3", de l'autre côté de la charge 2 par rapport à l'organe de commutation 3.

De même qui précédemment, il est possible de contrôler le fonctionnement complet du circuit incluant la charge, sans éventuellement activer cette dernière.

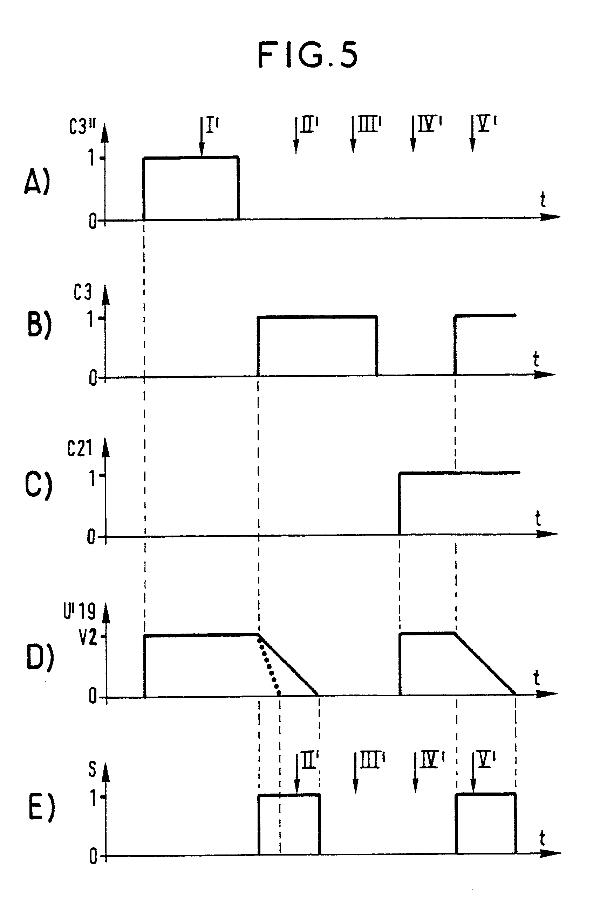

A cet effet dans une première phase, l'unité de commande 4 rend passant le transistor 3" ceci étant traduit par la présence d'un signal binaire de niveau un sur la figure 5A, alors que le thyristor 21 et l'organe de commutation 3 sont maintenus dans leur état bloqué traduit par un signal binaire de valeur zéro sur les diagrammes 5B, 5C. Ceci entraîne l'application du potentiel V2 au point P commun à la résistance 19 et à la capacité 20", -figure 5D-.

Un premier relevé I' effectué dans cette phase se traduit par un zéro binaire au niveau de la sortie S (figure 5E), sauf si l'organe de commutation 3 est passant par défaut.

Dans une seconde phase et après retour de l'organe de commutation 3" à l'état bloqué sur ordre de l'unité de commande 4, la mise à l'état conducteur de l'organe de commutation 3 entraîne la décharge de la capacité 20" au travers de la charge 2 et ramène le potentiel du point P au niveau 0 dans un délai fonction de la charge 2 et de la diode 30.

Un relevé II' effectué après l'actionnement de l'organe de commutation 3, dans un délai inférieur au temps normal de décharge de la capacité 20" au travers de la charge 2 et des résistances 12, 13, se traduit par un signal de valeur binaire un au niveau de la sortie S, sauf si la charge 2 est à l'état ouvert -voir le tracé un pointillé de la figure SD- ou en court-circuit éventuellement, par l'intermédiaire de la diode 30 -tracé un tireté de la figure SD-.

Un relevé III' effectué après le délai de décharge normal de la capacité 20 permet de vérifier que ni le transistor 3" ni le thyristor 21 ne sont conducteurs par suite d'un défaut.

L'activation du thyristor 21 après mise à l'état bloqué de l'organe de commutation 3 se traduit par un retour au potentiel +V2 du point P, sans effet à la sortie S de l'agencement d'entrée-sortie 18, si l'organe de commutation 3 n'est pas défectueusement passant -figures 5C à 5E-.

L'activation ultérieure de l'organe de commutation 3 -figure 5A-entraîne une baisse progressive de tension au point P dont la durée varie en fonction de la charge 2 et de la diode 30, entre un laps de temps très court si la charge 2 est en court-circuit, éventuellement par l'intermédiaire de la diode 30, à un laps très long si la charge est à l'état ouvert.

Un relevé V' effectué à l'intérieur du délai normal de décharge du condensateur 20" à travers la charge 2 et les résistances 12, 13, après la commande de déblocage appliquée à l'organe de commutation -figure 5B-, permet de vérifier en liaison avec le relevé précédent si la charge 2, le thyristor 21 et l'organe de commutation 3 sont en état convenable de fonctionnement. La mise en court-circuit rapide du thyristor permet éventuellement de ne pas déclencher la mise en service de la charge si besoin est.

La combinaison des résultats des relevés permet comme précédemment de cerner l'emplacement d'un défaut avant une mise en service de la charge en évitant les inconvénients de tentatives en conditions anormales.

## Revendications

1/ Agencement d'entrée-sortie, pour test préalable et commande d'une charge électrique (2) découplée par transformateur (5), caractérisé en ce qu'il comporte :
- une entrée (E) agissant sur un premier organe de commutation (6) inséré en série avec un enroulement primaire du transformateur dans un premier circuit d'alimentation, qu'il commande, de cet enroulement primaire ;
- une sortie (S) fournissant un signal à partir de la tension présente aux bornes d'une résistance (7), dite de sortie, reliée en série avec l'enroulement primaire du transformateur, dans le circuit d'alimentation de cet enroulement ;

- un circuit secondaire comportant un second organe de commutation (3) qui est inséré en série avec la charge dans un circuit d'alimentation, dit second circuit, qu'il commande, de cette charge et qui est commandé à partir de l'entrée de l'agencement, via le transformateur et un montage redresseur (10) connecté aux bornes d'un enroulement secondaire de ce transformateur, ledit circuit secondaire comportent de plus un montage commutateur d'impédance (13, 16) qui est sensible au courant d'alimentation traversant le second organe de commutation et qui est apte à commuter en conséquence une impédence auxiliaire (17) aux bornes du second enroulement pour agir sur la sortie de l'agencement en modifiant la tension aux bornes de la résistance, dite de sortie.

2/ Agencement d'entrée-sortie selon la revendication 1, caractérisé en ce que le montage commutateur d'impédance comporte un transistor (16) dont la base est reliée au point milieu d'un pont diviseur à deux résistances (12, 13) inséré en série avec la charge (2) et le second organe de commutation (3) dans le circuit d'alimentation de cette charge, ledit transistor (16) étant apte à connecter une résistance auxiliaire (17) aux bornes de l'enroulement secondaire du transformateur, lorsqu'il est activé.

3/ Agencement d'entrée-sortie selon au moins l'une des revendica tions 1 et 2, caractérisé en ce qu'il comporte un montage temporisateur (19, 14) inséré en amont de l'entrée de commande du second organe de commutation (3), derrière le montage commutateur d'impédance par rapport à l'enroulement secondaire du transformateur.

4/ Agencement d'entrée-sortie selon la revendication 2, comportant un troisième organe de commutation (3') inséré de l'autre côté de la charge (2) par rapport au second organe de commutation (3) dans le circuit d'alimentation de cette charge, caractérisé en ce qu'il comporte sur montage de test constitué par une résistance (19) et une capacité (20) en série formant un circuit série raccordé en parallèle au circuit formé par la charge, le circuit de commutation et le pont diviseur, en aval du troisième organe de commutation.

5/ Agencement d'entrée-sortie, selon la revendication 2 comportant un troisième organe de commutation qui est inséré de l'autre côté de la charge (2) par rapport au second organe de commutation (3) dans le circuit d'alimentation de cette charge et qui est constitué par un thyristor (21) en parallèle auquel sont raccordés un transistor (3") de mise en court-circuit de sa jonction anode-cathode et une capacité (20") caractérisé en ce qu'il comporte un montage de test associant une résistance (19) en série avec la capacité (20") entre les potentiels d'alimentation de ladite charge (2).

# FIG.1

# FIG.2

# FIG. 3

EP 0 433 514 A1

# FIG.4

FIG.5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-46962 (SIEMENS) <br> * le document en entier * <br> --- | 1, 3 | G08C25/02 <br> B61L1/20 <br> H03K17/18 |
| Y | US-A-4041327 (THOMAS) <br> * abrégé * <br> --- | 1, 3 | G08G1/097 |
| A | US-A-4661880 (FUTSUHARA) <br> * abrégé * <br> ----- | 1 | |

DOMAINES TECHNIQUES
RECHERCHES (Int. Cl.5)

G08C
B61L
H03K
G08G
G08R

Le présent rapport a été établi pour toutes les revendications

| Lieu de la recherche | Date d'achèvement de la recherche | Examinateur |
|---|---|---|
| LA HAYE | 20 JUILLET 1990 | REEKMANS M. V. |

EPO FORM 1503 03.82 (P0402)